(19) Europäisches Patentamt
European Patent Office
Office européen des brevets

(11) **EP 3 637 114 B1**

(12) **EUROPÄISCHE PATENTSCHRIFT**

(45) Veröffentlichungstag und Bekanntmachung des Hinweises auf die Patenterteilung:
**05.04.2023   Patentblatt 2023/14**

(21) Anmeldenummer: **19196128.3**

(22) Anmeldetag: **09.09.2019**

(51) Internationale Patentklassifikation (IPC):
***G01R 27/02*** *(2006.01)*

(52) Gemeinsame Patentklassifikation (CPC):
**G01R 27/025; H02H 3/16; H02M 3/158;**
G01R 31/007; G01R 31/343; G01R 31/52;
H02M 7/48

(54) **HOCHVOLTSYSTEM UND VERFAHREN ZUR ÜBERWACHUNG VON ISOLATIONSFEHLERN IN EINEM HOCHVOLTSYSTEM**

HIGH VOLTAGE SYSTEM AND METHOD FOR MONITORING INSULATING DEFECTS IN A HIGH VOLTAGE SYSTEM

SYSTÈME DE HAUT VOLTAGE ET PROCÉDÉ DE SURVEILLANCE DES ERREURS D'ISOLATION DANS UN SYSTÈME DE HAUT VOLTAGE

(84) Benannte Vertragsstaaten:
**AL AT BE BG CH CY CZ DK EE ES FI FR GB GR HR HU IE IS IT LI LT LU LV MC MK MT NL NO PL PT RO RS SE SI SK SM TR**

(30) Priorität: **08.10.2018   DE 102018217116**

(43) Veröffentlichungstag der Anmeldung:
**15.04.2020   Patentblatt 2020/16**

(73) Patentinhaber: **Volkswagen AG
38440 Wolfsburg (DE)**

(72) Erfinder:
• **Lehnhardt, Marcus
  38106 Braunschweig (DE)**
• **Albrecht, Fabian
  38114 Braunschweig (DE)**
• **Günther, Kay-Michael
  38239 Salzgitter (DE)**
• **Sommerfeld, Marcus
  38106 Braunschweig (DE)**

(56) Entgegenhaltungen:
EP-A1- 2 570 289          EP-A1- 2 796 887
DE-A1-102015 008 831      DE-B3-102006 031 663
US-A1- 2010 244 850       US-A1- 2017 227 589

**Beschreibung**

Die Erfindung betrifft ein Hochvoltsystem und ein Verfahren zur Überwachung von Isolationsfehlern in einem Hochvoltsystem.

Hochvoltsysteme sind meist als IT-Systeme ausgebildet und nicht mit Masse gleichspannungstechnisch verbunden. Die Isolation zwischen der positiven und negativen Hochvoltleitung muss dabei überwacht werden, da ein Kurzschluss zu einem großen Stromfluss nach Masse führen würde. Beispielsweise ist es bekannt, sogenannte Y-Kondensatoren hierzu zyklisch aufzuladen und deren Entladung zu messen, um daraus den Isolationswiderstand zu bestimmen. Diese Y-Kondensatoren (bzw. Cy-Kapazitäten) sind jeweils zwischen der Hochvoltleitung (positiv und negativ) und Masse angeordnet. Diese leiten HF-Störsignale nach Masse ab, die häufig durch Pulswechselrichter erzeugt werden. Bei Hochvoltsystemen mit einem DC/DC-Wandler, wo zwei unterschiedliche galvanisch verbundene Spannungsebenen existieren, kann jedoch im aktiven Betrieb des DC/DC-Wandlers die $C_Y$-Messung zur Ermittlung des Isolationswiderstandes nicht durchgeführt werden.

Aus der DE 10 2013 226 595 A1 ist eine Vorrichtung zur Isolationsüberwachung zwischen einem Niedervoltnetz und einem Hochvoltnetz bekannt, wobei die Vorrichtung sowohl mit einer Hochvoltplusverbindung als auch mit einer Hochvoltminusverbindung als auch mit dem Niedervoltnetz verbindbar ist, wobei die Vorrichtung eine Mehrzahl von elektrischen Kontakten zur Ankopplung von Überwachungsverbindungen an den Hochvoltkreis mittels jeweils einer Hochvoltplusverbindung und mittels jeweils einer Hochvoltminusverbindung aufweist, die in verschiedenen Abschnitten des Hochvoltnetzes verbindbar sind.

Aus der US 2017/227589 A1 ist ein Hochvoltsystem bekannt, umfassend eine Hochvoltbatterie und einen DC/DC-Wandler, wobei das Hochvoltsystem bei aktivem DC/DC-Wandler zwei unterschiedliche galvanisch verbundene Spannungsebenen aufweist, wobei das Hochvoltsystem eine erste Messeinrichtung zur Erfassung der Spannung der Hochvoltbatterie und eine zweite Messeinrichtung zur Erfassung der Spannung am Ausgang des DC/DC-Wandlers aufweist. Weiter weist das Hochvoltsystem eine dritte Messeinrichtung zur Erfassung einer Spannung zwischen einer positiven Hochvoltleitung und Masse und eine vierte Messeinrichtung zur Erfassung einer Spannung zwischen einer negativen Hochvoltleitung und Masse auf, wobei das Hochvoltsystem eine Isolationswächter-Einrichtung aufweist, die derart ausgebildet ist, aus den Daten der ersten bis vierten Messeinrichtung die Isolationswiderstände bei aktivem DC/DC-Wandler zu überwachen.

Aus der US 2010/243850 A1 ist ein Hochvoltsystem bekannt, umfassend eine Hochvoltbatterie und einen DC/DC-Wandler, wobei das Hochvoltsystem bei aktivem DC/DC-Wandler zwei unterschiedliche galvanisch verbundene Spannungsebenen aufweist. Weiter weist das Hochvoltsystem eine Isolationswiderstandsmesseinrichtung auf. Dabei weist das Hochvoltsystem eine dritte Messeinrichtung zur Erfassung einer Spannung zwischen einer positiven Hochvoltleitung und Masse auf.

Der Erfindung liegt das technische Problem zugrunde, ein Hochvoltsystem mit zwei galvanisch verbunden Spannungsebenen zu schaffen, bei dem kostengünstig und zuverlässig die Isolationswiderstände überwacht werden können, sowie ein zugehöriges Verfahren zur Überwachung von Isolationsfehlern zur Verfügung zu stellen.

Die Lösung des technischen Problems ergibt sich durch ein Hochvoltsystem mit den Merkmalen des Anspruchs 1 sowie ein Verfahren mit den Merkmalen des Anspruchs 8. Weitere vorteilhafte Ausgestaltungen der Erfindung ergeben sich aus den Unteransprüchen.

Hierzu umfasst das Hochvoltsystem eine Hochvoltbatterie und einen DC/DC-Wandler, wobei das Hochvoltsystem bei aktivem DC/DC-Wandler zwei unterschiedliche galvanisch verbundene Spannungsebenen aufweist. Dabei weist das Hochvoltsystem eine erste Messeinrichtung zur Erfassung der Spannung der Hochvoltbatterie und eine zweite Messeinrichtung zur Erfassung der Spannung am Ausgang des DC/DC-Wandlers auf. Dabei bezeichnet Ausgang die Seite des DC/DC-Wandlers, die von der Hochvoltbatterie abgewandt ist. Dabei sei angemerkt, dass der DC/DC-Wandler auch bidirektional ausgebildet sein kann. Weiter weist das Hochvoltsystem eine Isolationswiderstandsmesseinrichtung auf, die derart ausgebildet ist, nur bei deaktiviertem DC/DC-Wandler Isolationswiderstandsmessungen durchzuführen. Beispielsweise ist die Isolationswiderstandsmesseinrichtung als $C_Y$-Messeinrichtung ausgebildet, die die Entladekurven der Y-Kondensatoren auswertet. Weiter weist das Hochvoltsystem eine dritte Messeinrichtung zur Erfassung einer Spannung zwischen einer positiven Hochvoltleistung und Masse und eine vierte Messeinrichtung zur Erfassung einer Spannung zwischen einer negativen Hochvoltleistung und Masse auf, wobei das Hochvoltsystem eine Isolationswächter-Einrichtung aufweist, die derart ausgebildet ist, aus den Daten der ersten bis vierten Messeinrichtung die Isolationswiderstände mindestens bei aktivem DC/DC-Wandler zu überwachen. Da die erste und zweite Messeinrichtung üblicherweise bei Hochvoltsystemen vorhanden sind, besteht der schaltungstechnische Mehraufwand lediglich in der dritten und vierten Messeinrichtung sowie der Isolationswächter-Einrichtung. Diese kann als separates Steuergerät ausgebildet sein oder aber einfach in ein vorhandenes Steuergerät integriert werden, wie beispielsweise einem Batteriesteuergerät oder einem Motorsteuergerät. Ein bevorzugtes Anwendungsgebiet für das Hochvoltsystem ist ein Traktionsnetz in einem Kraftfahrzeug.

Dabei ist die Isolationswächter-Einrichtung derart ausgebildet, Isolationsfehler zwischen der positiven Hochvoltleitung des DC/DC-Wandlers und Masse dadurch zu detektieren, dass die Spannung der vierten Messeinrichtung größer als die Summe der ersten Messeinrichtung und einem Schwellwert ist und die Spannung dritten Messeinrichtung negativ ist. Der Vorteil ist, dass frühzeitig auf eine unzureichende Isolierung hingewiesen wird und so Beschädigungen von Bauteilen vermieden werden.

Vorzugsweise sind der Isolationswiderstand zwischen der positiven Hochvoltleitung und Masse und der Isolationswiderstand zwischen der negativen Hochvoltleitung und Masse gleich oder werden durch diskrete Symmetrierungs-Widerstände symmetriert, da dies die Auswertung erheblich vereinfacht.

In einer Ausführungsform ist der DC/DC-Wandler als Hochsetzsteller ausgebildet, d.h. die Spannung am Ausgang des DC/DC-Wandlers ist größer als die Spannung der Hochvoltbatterie. Ist der DC/DC-Wandler bidirektional ausgebildet, arbeitet dieser dann beim Laden der Hochvoltbatterie als Tiefsetzsteller.

In einer weiteren Ausführungsform sind am Ausgang des DC/DC-Wandlers ein Wechselrichter und eine Elektromaschine angeschlossen, wobei die Isolationswächter-Einrichtung derart ausgebildet ist, Isolationsfehler der Elektromaschine aufgrund von Wechselspannungskomponenten in den Daten der dritten und/oder vierten Messeinrichtung zu detektieren.

In einer weiteren Ausführungsform ist die Isolationswächter-Einrichtung derart ausgebildet, Isolationsfehler der Hochvoltleitungen zwischen der Hochvoltbatterie und dem DC/DC-Wandler dadurch zu detektieren, dass die Spannung der vierten oder dritten Messeinrichtung Null ist und die Spannung der dritten oder vierten Messeinrichtung gleich der Spannung der ersten Messeinrichtung ist. Der Grundgedanke dabei ist, dass bei einem Isolationsfehler einer der Hochvoltleitungen die Spannung der Hochvoltbatterie dann über der anderen Hochvoltleitung und Masse abfallen muss. Dabei kann alternativ ein Schwellwert X eingeführt werden, wobei auf einen Isolationsfehler erkannt wird, wenn das Potential über einer der Hochvoltleitungen und Masse kleiner als die Differenz der halben Spannung der Hochvoltbatterie und dem Schwellwert ist. Durch geeignete Wahl von X kann dann sehr frühzeitig auf eine geringe bzw. verringerte Isolation reagiert werden. Die halbe Spannung der Hochvoltbatterie setzt dabei die Symmetrierung der Isolationswiderstände voraus.

In einer weiteren Ausführungsform ist die Isolationswächter-Einrichtung derart ausgebildet, Isolationsfehler zwischen der negativen Hochvoltleitung des DC/DC-Wandlers und Masse dadurch zu detektieren, dass die Spannung der vierten Messeinrichtung Null ist und die Spannung der ersten und vierten Messeinrichtung gleich sind. Alternativ kann auch hier ein Schwellwert benutzt werden, um bereits frühzeitig auf einen Isolationsfehler bzw. eine nachlassende Isolation zu schließen.

Dabei kann weiter vorgesehen sein, dass das Hochvoltsystem mit einer Anzeigeeinheit verbunden ist, auf der die Ergebnisse der Isolationswiderstandsmessungen und die Ergebnisse der Isolationswächter-Einrichtung angezeigt werden, insbesondere wenn Fehler in der Isolation detektiert werden. Alternativ oder kumulativ können auch akustische Warnungen erfolgen.

In einer weiteren Ausführungsform ist das Hochvoltsystem derart ausgebildet, bei einem erfassten Isolationsfehler den DC/DC-Wandler zu deaktivieren. Vorzugsweise wird dann diese Deaktivierung dem Kraftfahrzeugführer über die Anzeigeeinheit oder akustisch mitgeteilt, sodass sich dieser darauf einstellen kann und eine Werkstatt aufsuchen kann.

Hinsichtlich der verfahrensmäßigen Ausgestaltung der Erfindung wird vollinhaltlich auf die vorangegangenen Ausführungen Bezug genommen.

Die Erfindung wird nachfolgend anhand eines bevorzugten Ausführungsbeispiels näher erläutert. Die einzige Figur zeigt eine schematische Darstellung eines Hochvoltsystems.

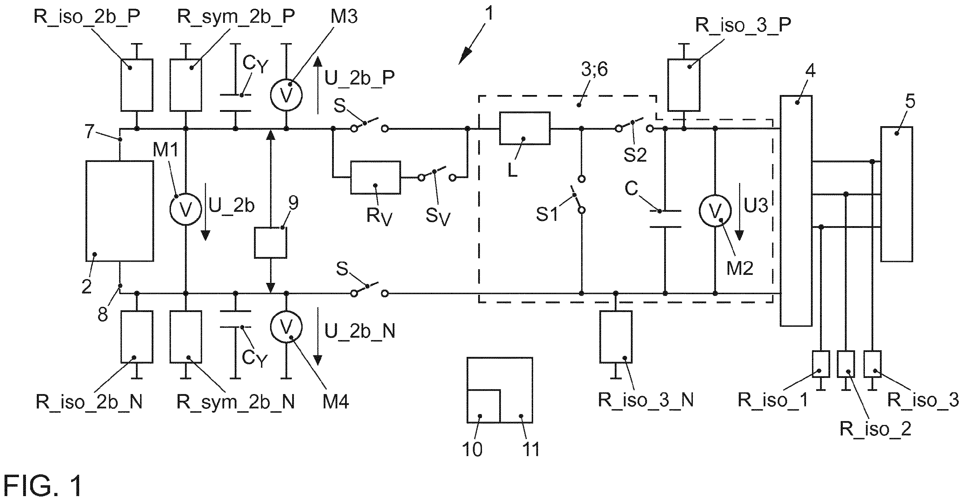

In der Fig. 1 ist ein Hochvoltsystem 1 dargestellt, das eine Hochvoltbatterie 2, einen DC/DC-Wandler 3, einen Wechselrichter 4 und eine Elektromaschine 5 aufweist. Der DC/DC-Wandler 3 ist als Hochsetzsteller 6 ausgebildet, sodass das Hochvoltsystem 1 zwei unterschiedliche galvanisch verbundene Spannungsebenen aufweist, nämlich die Spannungsebene der Hochvoltbatterie 2 und die Spannungsebene am Ausgang des Hochsetzstellers 6. Der Hochsetzsteller 6 weist eine Induktivität L, eine Kapazität C und zwei Schaltelemente S1, S2 auf, wobei die Funktionalität des Hochsetzstellers 6 hier nicht näher erläutert werden soll. Des Weiteren weist das Hochvoltsystem 1 zwei Schütze S auf, mittels derer die Hochvoltbatterie 2 allpolig vom übrigen Hochvoltsystem 1 galvanisch getrennt werden kann. Zusätzlich ist ein Vorladewiderstand Rv und ein Vorladerelais Sv dargestellt. Anstelle der Schütze S können auch Halbleiterschalter zum Einsatz kommen. Weiter weist das Hochvoltsystem 1 eine erste Messeinrichtung M1 auf, die die Spannung $U\_2b$ der Hochvoltbatterie 2 misst. Eine zweite Messeinrichtung M2 misst die Ausgangsspannung U3 des Hochsetzstellers 6. Zwischen einer positiven Hochvoltleitung 7 und Masse sowie einer negativen Hochvoltleitung 8 und Masse ist jeweils ein Y-Kondensator $C_Y$ zur Entstörung angeordnet. Weiter bildet sich zwischen der positiven Hochvoltleitung 7 und Masse ein Isolationswiderstand $R\_iso\_2b\_P$ aus. Entsprechend bildet sich zwischen der negativen Hochvoltleitung 8 und Masse ein Isolationswiderstand $R\_iso\_2b\_N$ aus. Für den Fall, dass die beiden sich ausbildenden Isolationswiderstände $R\_iso\_2b\_P$ und $R\_iso\_2b\_N$ nicht gleich sind, werden diskrete Symmetrierungswiderstände $R\_sym\_2b\_P$, $R\_sym\_2b\_N$ zwischen die Hochvoltleitungen 7, 8 und Masse geschaltet, sodass die beiden Parallelschaltungen einen gleich großen Isolationswiderstand bilden. Weiter ist eine dritte Messeinrichtung M3 vorgesehen, die die Spannung U_2b_P zwischen der positiven Hochvoltleitung 7 und Masse erfasst. Entsprechend ist eine vierte Messeinrichtung M4 vorgesehen, die die Spannung U_2b_N zwischen der negativen Hochvoltleitung 8 und Masse erfasst. Entsprechend bildet sich auch ein Isolationswiderstand P_iso_3_P bzw. P_iso_3_N zwischen der positiven Hochvoltleitung am Hochsetzsteller 6 und Masse bzw. der negativen Hochvoltleitung am Hochsetzsteller 6 und Masse aus. Schließlich bilden sich auch Isolationswiderstände R_iso_1 - R_iso_3 zwischen den drei Phasenleitungen der Elektromaschine 5 und Masse aus. Weiter weist das Hochvoltsystem 1 eine Isolationswiderstandsmesseinrichtung 9 auf, die derart ausgebildet ist, den Isolationswiderstand bei deaktiviertem DC/DC-Wandler 2 zu messen, beispielsweise indem das Entladeverhalten der Y-Kondensatoren C_Y ausgewertet wird. Aber auch andere Messeinrichtungen sind möglich. Schließich weist das Hochvoltsystem 1 eine Isolationswächter-Einrichtung 10 auf, die beispielsweise in einem Motorsteuergerät 11 integriert ist. Die Isolationswächter-Einrichtung 10 wertet hierzu im aktiven Betrieb des DC/DC-Wandlers 3 die Spannungen der vier Messeinrichtungen M1-M4 aus, um auftretende Isolationsfehler zu detektieren.

Die Funktionsweise der Isolationswächter-Einrichtung 10 soll nun nachfolgend näher erläutert werden.

Bei deaktiviertem DC/DC-Wandler 3 und fehlerfreiem Zustand gilt:

$$U\_2b = U\_3 \text{ und } U\_2b\_N = U\_2b\_P$$

Wird nun eine aktive Isolationsmessung durch die Isolationswiderstandsmesseinrichtung 9 durchgeführt (z.B. mittels C_Y-Umladung), so muss gelten:

$$U\_2b\_N \leq U\_2b \text{ und } U\_2b\_P \leq U\_2b \text{ und } U\_2b\_N + U\_2b\_P = U\_2b$$

Anders ausgedrückt muss die Summe der beiden Spannungen über der positiven Hochvoltleitung 7 und Masse sowie der negativen Hochvoltleitung 8 und Masse gleich der Spannung der Hochvoltbatterie 2 sein, wobei keine der Spannungen größer als die Spannung der Hochvoltbatterie 2 sein darf.

Bei aktivem DC/DC-Wandler 3 bzw. Hochsetzsteller 6 muss gelten:

$$U\_3 > U\_2b$$

$$U\_2b\_N = U\_3 \times (R\_sym\_2b\_N \| R\_iso\_2b\_N \| R\_iso\_3\_N) /$$
$$((R\_sym\_2b\_N \| R\_iso\_2b\_N \| R\_iso\_3\_N) + (R\_iso\_3\_P \| AC\text{-Teil}))$$

wobei sich der AC-Teil aus der Parallelschaltung der drei Isolationswiderstände R_iso_1 - R_iso_3 zusammensetzt.

Bei einem Isolationsfehler von R_iso_2b_N oder R_iso_3_N gilt:

$$U\_2b\_N = 0 \text{ V und } U\_2b\_P = U\_2b$$

Um nun den Beginn einer nachlassenden Isolierung zu erfassen, kann ein Schwellwert X gewählt werden, wobei bereits bei $U\_2b\_N < \dfrac{U\_2b}{2} - x$ auf einen Isolationsfehler geschlossen wird. Dabei gilt weiter $U\_2b\_P < \dfrac{U\_2b}{2} + x$ und $U\_2b\_P \geq 0$.

Entsprechend kann auf eine nachlassende Isolierung geschlossen werden, wenn $U\_2b\_P < \dfrac{U\_2b}{2} - x$ ist, wobei zusätzlich gelten muss, dass $U\_2b\_N < \dfrac{U\_2b}{2} + x$ und $U\_2b\_N \geq 0$ ist.

Des Weiteren kann mittels der Isolationswächter-Einrichtung 10 ein Fehler der Isolierung von der positiven Hochvoltleitung 7 am Hochsetzsteller 6 zur Masse detektiert werden.

Im Kurzschlussfall gilt U_2b_N = U_3 und U_2b_P = U_2b - U_2b_N.

Dieser Fall kann dazu führen, dass es zu einer Überlastung des Isolationswiderstandes R_iso_2b_N kommt, was je nach Auslegung zu einer Überlastung von Bauteilen führen kann.

Daher kommt auch hier vorzugsweise ein Schwellwert X zum Einsatz, sodass bereits auf einem Isolationsfehler erkannt wird, wenn gilt U_2b_N > U_2b + x und U_2B_P < 0.

Dabei sei angemerkt, dass der Schwellwert X für die Erkennung eines Fehlers von R_iso_3_P nicht gleich dem Schwellwert X für die Erkennung eines Isolationsfehlers von R_iso_2b_N bzw. R_iso_3_N sein muss.

Isolationsfehler im AC-Antriebsteil (z.B. bei R_iso_1) können dadurch detektiert werden, dass die dritten und vierten Messeinrichtungen M3, M4 einen Wechselspannungsanteil messen.

Weiter sei angemerkt, dass durch Öffnen der Schütze S die Isolationswiderstandsmesseinrichtung 9 den internen Isolationswiderstand der Hochvoltbatterie 2 messen kann und durch Schließen der Schütze vor der Messung den Gesamtisolationswiderstand messen kann. Des Weiteren können die Messergebnisse von der dritten und vierten Messeinrichtung zur Plausibilisierung der Isolationswiderstandsmessung herangezogen werden.

**Patentansprüche**

1. Hochvoltsystem (1), umfassend eine Hochvoltbatterie (2) und einen DC/DC-Wandler (3), wobei das Hochvoltsystem (1) bei aktiven DC/DC-Wandler (3) zwei unterschiedliche galvanisch verbundene Spannungsebenen aufweist, wobei das Hochvoltsystem (1) weiter zwei Schütze (S) aufweist, mittels derer die Hochvoltbatterie (2) allpolig vom übrigen Hochvoltsystem (1) galvanisch getrennt werden kann, wobei das Hochvoltsystem (1) eine erste Messeinrichtung (M1) zur Erfassung der Spannung (U_2b) der Hochvoltbatterie (2) und eine zweite Messeinrichtung (M2) zur Erfassung der Spannung (U3) am Ausgang des DC/DC-Wandlers (3) aufweist, wobei das Hochvoltsystem (1) eine Isolationswiderstandsmesseinrichtung (9) aufweist, die derart ausgebildet ist, nur bei deaktiviertem DC/DC-Wandler (3) Isolationswiderstandsmessungen durchzuführen, wobei die Isolationswiderstandsmesseinrichtung (9) derart ausgebildet ist, bei offenen Schützen (S) den internen Isolationswiderstand der Hochvoltbatterie (2) und bei geschlossenen Schützen (S) den Gesamtisolationswiderstand zu messen, wobei das Hochvoltsystem (1) weiter eine dritte Messeinrichtung (M3) zur Erfassung einer Spannung (U_2b_P) zwischen einer positiven Hochvoltleitung (7) und Masse und eine vierte Messeinrichtung (M4) zur Erfassung einer Spannung (U_2b_N) zwischen einer negativen Hochvoltleitung (8) und Masse aufweist, wobei das Hochvoltsystem (1) eine Isolationswächter-Einrichtung (10) aufweist, die derart ausgebildet ist, aus den Daten der ersten bis vierten Messeinrichtung (M1-M4) verschiedene weitere Isolationswiderstände der Hochvoltbatterie (2) bei aktivem DC/DC-Wandler (3) zu überwachen, wobei die Isolationswächter-Einrichtung (10) derart ausgebildet ist, Isolationsfehler zwischen der positiven Hochvoltleitung des DC/DC-Wandlers (3) und Masse dadurch zu detektieren, dass die Spannung der vierten Messeinrichtung (M4) größer als die Summe der von der ersten Messeinrichtung (M1) erfassten Spannung (U_2b) und einem Schwellwert (X) ist und die Spannung der dritten Messeinrichtung (M3) negativ ist.

2. Hochvoltsystem nach Anspruch 1, **dadurch gekennzeichnet, dass** der Isolationswiderstand (R_iso_2b_P) zwischen der positiven Hochvoltleitung (7) und Masse und der Isolationswiderstand (R_iso_2b_N) zwischen der negativen Hochvoltleitung (8) und Masse gleich sind oder durch diskrete Symmetrierungs-Widerstände (R_sym_2b_P, R_sym_2b_N) symmetriert sind.

3. Hochvoltsystem nach Anspruch 1 oder 2, **dadurch gekennzeichnet, dass** der DC/DC-Wandler (3) als Hochsetzsteller (6) ausgebildet ist.

4. Hochvoltsystem nach einem der vorangegangenen Ansprüche, **dadurch gekennzeichnet, dass** am Ausgang des DC/DC-Wandlers (3) ein Wechselrichter (4) und eine Elektromaschine (5) angeschlossen sind, wobei die Isolationswächter-Einrichtung (10) derart ausgebildet ist, Isolationsfehler der Elektromaschine (5) aufgrund von Wechselspannungskomponenten in den Daten der dritten und/oder vierten Messeinrichtung (M3, M4) zu detektieren.

5. Hochvoltsystem nach einem der vorangegangenen Ansprüche, **dadurch gekennzeichnet, dass** die Isolationswächter-Einrichtung (10) derart ausgebildet ist, Isolationsfehler der Hochvoltleitungen (7, 8) zwischen der Hochvoltbatterie (2) und dem DC/DC-Wandler (3) dadurch zu detektieren, dass die Spannung der vierten oder dritten Messeinrichtung (M4, M3) Null ist und die Spannung der dritten oder der vierten Messeinrichtung (M4, M3) gleich der Spannung der ersten Messeinrichtung (M1) ist.

6. Hochvoltsystem nach einem der vorangegangenen Ansprüche, **dadurch gekennzeichnet, dass** die Isolationswächter-Einrichtung (10) derart ausgebildet ist, Isolationsfehler zwischen der negativen Hochvoltleitung des DC/DC-Wandlers (3) und Masse dadurch zu detektieren, dass die Spannung der vierten Messeinrichtung (M4) Null ist und die Spannung der ersten Messeinrichtung (M1) und dritten Messeinrichtung (M3) gleich sind.

**7.** Hochvoltsystem nach einem der vorangegangenen Ansprüche, **dadurch gekennzeichnet, dass** das Hochvoltsystem (1) derart ausgebildet ist, bei einem erfassten Isolationsfehler den DC/DC-Wandler (3) zu deaktivieren.

**8.** Verfahren zur Überwachung von Isolationsfehlern in einem Hochvoltsystem (1) gemäß einem der vorangegangen Ansprüche.

**Claims**

**1.** High-voltage system (1), comprising a high-voltage battery (2) and a DC-to-DC converter (3), wherein the high-voltage system (1) has two different, galvanically connected voltage levels when the DC-to-DC converter (3) is active, wherein the high-voltage system (1) also has two contactors (S), by means of which the high-voltage battery (2) can be galvanically isolated from the rest of the high-voltage system (1) at all poles, wherein the high-voltage system (1) has a first measuring apparatus (M1) for detecting the voltage (U_2b) of the high-voltage battery (2) and a second measuring apparatus (M2) for detecting the voltage (U3) at the output of the DC-to-DC converter (3), wherein the high-voltage system (1) has an insulation resistance measuring apparatus (9) that is designed to carry out insulation resistance measurements only when the DC-to-DC converter (3) is deactivated, wherein the insulation resistance measuring apparatus (9) is designed to measure the internal insulation resistance of the high-voltage battery (2) when the contactors (S) are open and to measure the total insulation resistance when the contactors (S) are closed, wherein the high-voltage system (1) also has a third measuring apparatus (M3) for detecting a voltage (U_2b_P) between a positive high-voltage line (7) and earth, and a fourth measuring apparatus (M4) for detecting a voltage (U_2b_N) between a negative high-voltage line (8) and earth, wherein the high-voltage system (1) has an insulation monitoring apparatus (10) that is designed to monitor, from the data from the first to fourth measuring apparatuses (M1-M4), different further insulation resistances of the high-voltage battery (2) when the DC-to-DC converter (3) is active, wherein the insulation monitoring apparatus (10) is designed to detect insulation faults between the positive high-voltage line of the DC-to-DC converter (3) and earth by virtue of the voltage of the fourth measuring apparatus (M4) being greater than the sum of the voltage (U_2b) detected by the first measuring apparatus (M1) and a threshold value (X), and the voltage of the third measuring apparatus (M3) being negative.

**2.** High-voltage system according to Claim 1, **characterized in that** the insulation resistance (R_iso_2b_P) between the positive high-voltage line (7) and earth and the insulation resistance (R_iso_2b_N) between the negative high-voltage line (8) and earth are equal or are balanced by way of discrete balancing resistors (R_sym_2b_P, R_sym_2b_N).

**3.** High-voltage system according to Claim 1 or 2, **characterized in that** the DC-to-DC converter (3) is in the form of a step-up converter (6).

**4.** High-voltage system according to one of the preceding claims, **characterized in that** an inverter (4) and an electric machine (5) are connected to the output of the DC-to-DC converter (3), wherein the insulation monitoring apparatus (10) is designed to detect insulation faults in the electric machine (5) on account of AC voltage components in the data from the third and/or fourth measuring apparatuses (M3, M4).

**5.** High-voltage system according to one of the preceding claims, **characterized in that** the insulation monitoring apparatus (10) is designed to detect insulation faults in the high-voltage lines (7, 8) between the high-voltage battery (2) and the DC-to-DC converter (3) by virtue of the voltage of the fourth or the third measuring apparatus (M4, M3) being zero, and the voltage of the third or the fourth measuring apparatus (M4, M3) being equal to the voltage of the first measuring apparatus (M1) .

**6.** High-voltage system according to one of the preceding claims, **characterized in that** the insulation monitoring apparatus (10) is designed to detect insulation faults between the negative high-voltage line of the DC-to-DC converter (3) and earth by virtue of the voltage of the fourth measuring apparatus (M4) being zero, and the voltage of the first measuring apparatus (M1) and of the third measuring apparatus (M3) being equal.

**7.** High-voltage system according to one of the preceding claims, **characterized in that** the high-voltage system (1) is designed to deactivate the DC-to-DC converter (3) if an insulation fault is detected.

**8.** Method for monitoring insulation faults in a high-voltage system (1) according to one of the preceding claims.

**Revendications**

1. Système haute tension (1), comprenant une batterie haute tension (2) et un convertisseur DC/DC (3), dans lequel, lorsque le convertisseur DC/DC (3) est actif, le système haute tension (1) présente deux niveaux de tension différents, reliés galvaniquement, dans lequel le système haute tension (1) présente en outre deux disjoncteurs (S) au moyen desquels la batterie haute tension (2) peut être isolée galvaniquement sur tous les pôles du reste du système haute tension (1), dans lequel le système haute tension (1) présente un premier dispositif de mesure (M1) pour enregistrer la tension (U_2b) de la batterie haute tension (2) et un deuxième dispositif de mesure (M2) pour enregistrer la tension (U3) à la sortie du convertisseur DC/DC (3), dans lequel le système haute tension (1) présente un dispositif de mesure de résistance d'isolement (9) qui est réalisé de façon à n'effectuer des mesures de résistance d'isolement que lorsque le convertisseur DC/DC (3) est désactivé, dans lequel le dispositif de mesure de résistance d'isolement (9) est réalisé de façon à mesurer la résistance d'isolement interne de la batterie haute tension (2) lorsque les disjoncteurs (S) sont ouverts et à mesurer la résistance d'isolement totale lorsque les disjoncteurs (S) sont fermés, dans lequel le système haute tension (1) présente en outre un troisième dispositif de mesure (M3) pour enregistrer une tension (U_2b_P) entre une ligne haute tension positive (7) et la masse et présente un quatrième dispositif de mesure (M4) pour enregistrer une tension (U_2b_N) entre une ligne haute tension négative (8) et la masse, dans lequel le système haute tension (1) présente un dispositif moniteur d'isolement (10) qui est réalisé de façon à surveiller selon les données des premier à quatrième dispositifs de mesure (M1 à M4) différentes résistances d'isolement supplémentaires de la batterie haute tension (2) lorsque le convertisseur DC/DC (3) est actif, dans lequel le dispositif moniteur d'isolement (10) est réalisé de façon à détecter des défauts d'isolement entre la ligne haute tension positive du convertisseur DC/DC (3) et la masse en ce que la tension du quatrième dispositif de mesure (M4) est supérieure à la somme de la tension (U_2b) enregistrée par le premier dispositif de mesure (M1) et d'une valeur seuil (X), et la tension du troisième dispositif de mesure (M3) est négative.

2. Système haute tension selon la revendication 1, **caractérisé en ce que** la résistance d'isolement (R_iso_2b_P) entre la ligne haute tension positive (7) et la masse et la résistance d'isolement (R_iso_2b_N) entre la ligne haute tension négative (8) et la masse sont identiques ou sont équilibrées par des résistances d'équilibrage discrètes (R_sym_2b_P, R_sym_2b_N).

3. Système haute tension selon la revendication 1 ou 2, **caractérisé en ce que** le convertisseur DC/DC (3) est réalisé sous forme de convertisseur élévateur (6).

4. Système haute tension selon l'une quelconque des revendications précédentes, **caractérisé en ce qu'**un onduleur (4) et une machine électrique (5) sont connectés à la sortie du convertisseur DC/DC (3), dans lequel le dispositif moniteur d'isolement (10) est réalisé de façon à détecter des défauts d'isolement de la machine électrique (5) dus à des composantes de tension alternative dans les données du troisième et/ou du quatrième dispositif de mesure (M3, M4).

5. Système haute tension selon l'une quelconque des revendications précédentes, **caractérisé en ce que** le dispositif moniteur d'isolement (10) est réalisé de façon à détecter des défauts d'isolement des lignes haute tension (7, 8) entre la batterie haute tension (2) et le convertisseur DC/DC (3) **en ce que** la tension du quatrième ou du troisième dispositif de mesure (M4, M3) est zéro et la tension du troisième ou du quatrième dispositif de mesure (M4, M3) est identique à la tension du premier dispositif de mesure (M1).

6. Système haute tension selon l'une quelconque des revendications précédentes, **caractérisé en ce que** le dispositif moniteur d'isolement (10) est réalisé de façon à détecter des défauts d'isolement entre la ligne haute tension négative du convertisseur DC/DC (3) et la masse **en ce que** la tension du quatrième dispositif de mesure (M4) est zéro et la tension du premier dispositif de mesure (M1) et la tension du troisième dispositif de mesure (M3) sont identiques.

7. Système haute tension selon l'une quelconque des revendications précédentes, **caractérisé en ce que** le système haute tension (1) est réalisé de façon à désactiver le convertisseur DC/DC (3) si un défaut d'isolement est enregistré.

8. Procédé permettant de surveiller des défauts d'isolement dans un système haute tension (1) selon l'une quelconque des revendications précédentes.

FIG. 1

**IN DER BESCHREIBUNG AUFGEFÜHRTE DOKUMENTE**

**In der Beschreibung aufgeführte Patentdokumente**

- DE 102013226595 A1
- US 2017227589 A1
- US 2010243850 A1